# EUROPEAN PATENT SPECIFICATION

(11) **EP 0 378 061 B1**
(45) Date of publication and mention of the grant of the patent: **28.02.1996**
(21) Application number: 89850440.2
(22) Date of filing: 18.12.1989
(51) Int. Cl.: G02F 1/37, H01S 3/133

(54) **Apparatus and method for producing blue-green light radiation**
Verfahren und Vorrichtung zur Erzeugung von blaugrüner Lichtstrahlung
Dispositif et méthode pour la production de radiation lumineuse bleue-verte

(30) Priority: 13.01.1989 US 297461
(43) Date of publication of application: 18.07.1990
(73) Proprietor: International Business Machines Corporation, Armonk, N.Y. 10504 (US)
(72) Inventor: Harder, Christoph Stephan, CH-8038 Zurich (CH); Lenth, Wilfried, Capitola, CA 95010 (US); Meier, Heinz Peter, CH-8800 Thalwil (CH); Risk, William Paul, Mountain View, CA 94043 (US)
(74) Representative: Burt, Roger James, Dr.

(56) References cited:
- APPLIED OPTICS, vol. 26, no. 12, 15th June 1987, pages 2390-2394; T.Y. FAN et al.: "Second harmonic generation and accurate index of refraction measurements in flux-grown KTiOPO4"
- NOV. J. QUANTUM ELECTRON., vol. 15, no. 7, July 1985, pages 885-886, American Institute of Physics; A.L. ALEKSANDROVSKII et al.: "Efficient nonlinear optical converters made of potassium titanyl phosphate crystals"
- APPL. PHYS. LETT., vol. 49, no. 24, 15th December 1986, pages 1659-1660, American Institute if Physics; D. FEKETA et al: "Graded-index separate-cinfinement InGaAs/GaAs strained-layer quantum well laser grown by metalorganic chemical vapor deposition"
- APPLIED PHYSICS LETTERS, vol. 55, no. 12, 18th September 1989, pages 1179-1181; W.P. RISK et al.: "Noncritically phase-matched frequency doubling using 994 nm dye and diode laser radiation in KTiOPO4"

## Description

### Background of the Invention

### Field of the Invention

This invention relates to a laser source and method for producing coherent blue-green-light radiation, and more particularly relates to a miniature solid-state laser source and method for producing said radiation by second-harmonic generation of the output of a semiconductor diode laser in a nonlinear crystal that permits noncritical phase matching over a wide range of temperatures, angles and input wavelength, rendering it especially suitable for optical storage applications.

Blue-green lasers are desirable because they permit a significant enhancement of the storage density of an optical recording system. However, fundamental material fabrication problems are encountered in developing diode lasers operating at wavelengths <600 nm (i.e., in the blue-green range).

Insofar as we are aware, there are only two reported examples of direct frequency doubling of diode laser radiation by second-harmonic generation (SHG). T. Taniuchi et al. reported in CLEO 87, Paper WP6, discloses generation of essentially 420 nm radiation by SHG of a GaAlAs diode laser using a LiNbO₃ waveguide. However, this material does not permit phase-matched SHG at 420 nm, and the blue-green light has a curved wavefront that cannot be focussed to a diffraction-limited spot and hence is unsuitable for optical storage and many other uses. Also, LiNbO₃ has a relatively low optical damage threshold due to photorefractive processes.

J.C. Baumert et al, in APPLIED OPTICS, Volume 24, page 1299 (1985) reported that frequency doubling of 860 nm GaAlAs diode lasers can be achieved with KNbO₃ at room temperature; but this material has many disadvantages that severely limit its suitability for practical devices. For example, KNbO₃ is difficult to grow and undergoes two phase transitions between the growth temperature and room temperature. Also the temperature and wavelength tolerances for phase matching are extremely narrow, and therefore would require a laser of very specific wavelength and also precise temperature stabilization of the SHG crystal.

T.Y. Fan et al, in APPLIED OPTICS, Volume 24, page 2390 (1987) reported that frequency doubling of 1064 nm Nd:YAG diode lasers can be achieved with a nonlinear crystal of essentially KTiOPO₄ (KTP). This is achieved by non-critically phase matched second-harmonic generation of the beam. Frequency doubling at other frequencies is not disclosed.

Other related approaches use diode-laser pumped Nd:YAG lasers to generate 530 nm radiation by phase-matched SHG since suitable nonlinear materials are available for this process. Similarly, frequency mixing of an 808 nm diode laser and a 1.06 µm Nd:YAG laser is possible in the commercially available nonlinear material KTiOPO₄ (KTP), as disclosed in U.S. Patent 4,791,631 issued December 13, 1988, assigned to the assignee of the present invention.

There is a need for a practical nonlinear material which can be cut for noncritically phase-matched SHG of the shortest wavelength possible and combined with a semiconductor diode laser that operates at the phase-matching wavelength. Insofar as applicants are aware, coherent radiation has never heretofore been provided by SHG of a diode laser in a nonlinear crystal consisting essentially of KTP.

### Summary of the Invention

The present invention is defined in the attached claims.

Towards this end and according to the invention, a miniature blue-green laser source has been developed that has two key components: (a) a semiconductor diode laser recently developed by others and having a wavelength of essentially 980-1,000 nm; and (b) a crystal of KTP that applicants unexpectedly found to permit noncritical type II phase-matched SHG of essentially 980-1,000 nm radiation over a wide range of temperatures, input wavelengths and angles of the input beam to the crystal.

The apparatus and method embodying the invention produce coherent blue-green-light radiation having a wavelength of essentially 490-500 nm. A diode laser, such as a strained-layer InGaAs/GaAs, semiconductor laser, provides an essentially 980-1000 nm beam, and a nonlinear crystal of essentially KTP produces the blue-green radiation by noncritically phase-matched SHG of said beam. The beam preferably has a wavelength of 994 nm for generating 497 nm radiation. Also the frequency of the laser is preferably matched and locked to that of an optical resonator within which the crystal is disposed.

### Brief Description of the Drawing

Fig. 1 is a schematic diagram of a resonator-enhanced apparatus for generating blue-green light, according to one embodiment of the invention;
Fig. 2 is a schematic diagram of such an apparatus according to another embodiment of the invention;
Fig. 3 is a schematic diagram of a resonator-enhanced apparatus for generating blue-green light, according to a modified embodiment; and
Fig. 4 is a schematic diagram of an apparatus for generating blue-green light using an optical waveguide according to a variation of the invention.

### Description of Preferred Embodiments

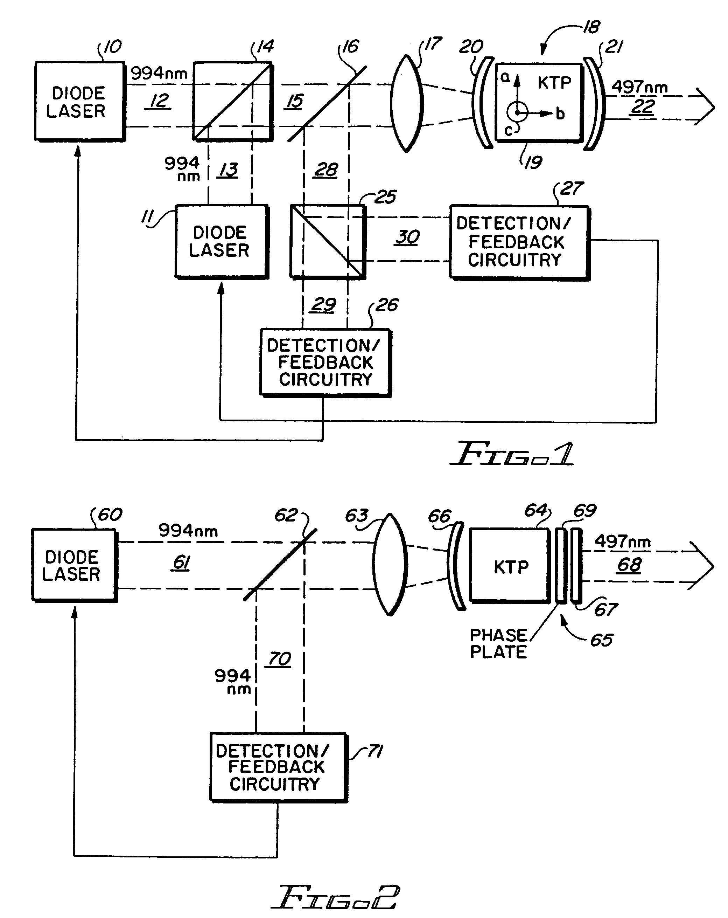

As illustrated in Fig. 1, the apparatus embodying the invention comprises two strained-layer InGaAs/GaAs diode lasers 10, 11 with collimation optics and modulated output beams 12, 13, respectively, that each provide essentially 994 nm fundamental radiation. Beams 12, 13 are orthogonally polarized and directed to a conventionally coated polarization beamsplitter 14. Beamsplitter 14 combines the 994 nm beams 12, 13 into a beam 15 that is directed to a standard beamsplitter 16. Beamsplitter 16 passes the 994 nm fundamental radiation via a focussing lens 17 to a passive Fabry-Perot resonator 18. Resonator 18 is resonant at a wavelength of 994 nm. It may be formed by placing a crystal 19 consisting of essentially KTP between two mirrors 20, 21 which are highly reflective at 994 nm; or, if preferred, resonator 18 may be formed by polishing spherical and/or flat surfaces at opposite ends of the crystal and depositing highly reflective coatings thereon. Mirrors 20, 21 have facing surfaces that reflect the 994 nm; and mirror 21 transmits the 497 nm radiation.

The birefringence of KTP crystal 19 causes the resonator 18 to have two sets of resonant modes. Laser diode 10 is linearly polarized along the a-axis of the KTP crystal and is frequency locked, in the manner hereafter described, to the a-axis polarized resonance of the resonator. Laser diode 11 is polarized along the c-axis of the crystal and is similarly frequency locked to the c-axis polarized resonator resonance. The beam 15 of essentially 994 nm radiation is focussed by lens 17 into, and is propagated along the b-axis of, KTP crystal 19, thereby producing a beam 22 of coherent blue-green-light radiation at essentially 497 nm by noncritically phase-matched SHG of beam 15. The frequencies of these two resonances may not be identical; however, as long as they are within the 1.4 nm wide phase-matching bandwidth for SHG, beam 22 will be efficiently produced.

The diode lasers 10, 11 are frequency locked to the resonances of the resonator 18 by respective feedback loops that comprise a polarization beamsplitter 25 and two detection and feedback circuits 26, 27. Beamsplitter 16 directs a beam 28 of 994 nm radiation to beamsplitter 25 which then splits said beam into an a-axis polarized beam 29 and a c-axis polarized beam 30. Beam 29 is directed to detection/feedback circuit 26 which may, for sake of illustration, be of the type disclosed in the April 1987 issue of "IEEE Journal of Lightwave Technology" at pp. 485 et seq. This circuit 26 comprises briefly means (not shown) for generating a signal indicative of deviations in the frequency of the beam 12 from the frequency of the resonator 18 and for adjusting the injection current to diode laser 10 and/or its temperature to maintain the laser frequency at the resonator frequency. Beam 30 is directed to detection/feedback circuit 27 which comprises similar means (not shown) to adjust the injection current to diode laser 11 and/or its temperature.

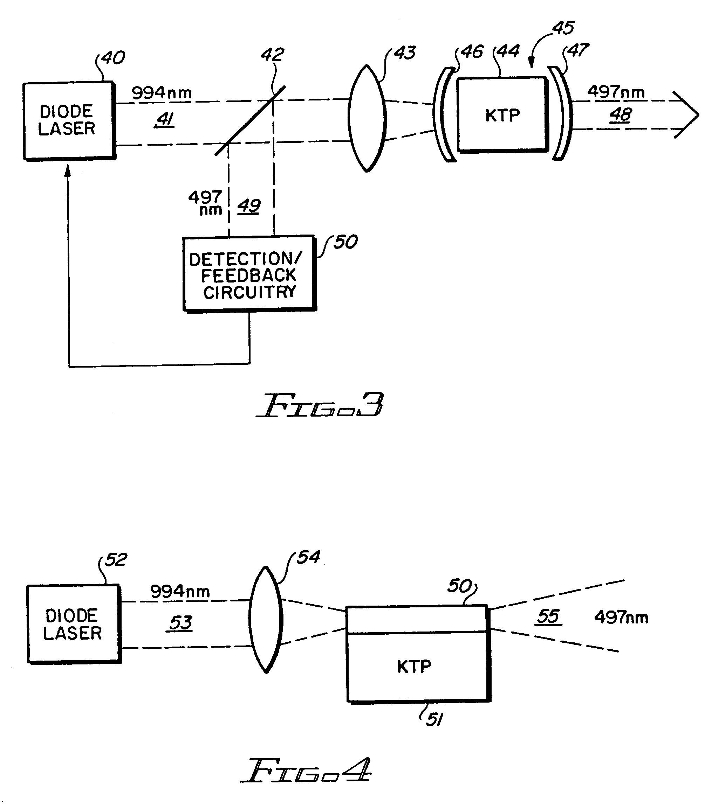

As illustrated in Fig. 2, the apparatus embodying the invention comprises a single strained-layer InGaAs/GaAs diode laser 60 with collimation optics and output beam 61 to provide essentially 994 nm fundamental radiation of linear polarization. Crystal 64 of essentially KTP is part of a passive resonator 65. Mirrors 66, 67 at opposite ends of crystal 64 are highly reflective at 994 nm. Mirror 67 is highly transmissive at 497 nm. The nonlinear crystal 64 is oriented such that its a- and c- axes are at an angle of 45 degrees to the polarization of the essentially 994 nm beam 61 for Type II noncritically phasematched second harmonic generation. The phaseplate 69 is oriented such that it corrects the polarization of the 994 nm radiation emerging from the crystal 64 so that the 994 nm radiation has a polarization direction of 45 degrees with respect to the a- and c- axes of the KTP crystal 64 when it re-enters the crystal after a round-trip pass through the resonator. The diode laser 60 is frequency locked to the resonance of the resonator 65 by a feedback loop which comprises a beam splitter 62 and the detection and feedback circuitry 71. The feedback circuitry 71, as described in connection with the embodiment of Fig. 1, adjusts the injection current to diode laser 60 and/or its temperature.

As illustrated in Fig. 3, the apparatus embodying the invention comprises a single strained-layer InGaAs/GaAs diode laser 40 with collimation optics and modulated output beam 41 to provide essentially 994 nm fundamental radiation. Beam 41 is directed through a dichroic beamsplitter 42 and a focussing lens 43 into a crystal 44 of essentially KTP that forms part of a passive resonator 45. Mirrors 46, 47 (or highly reflective coatings) at opposite ends of crystal 44 are highly reflective at 497 nm; but mirror 47 has a residual small transmission at 497 nm adjusted for maximum blue-green output power for the characteristics of the particular KTP crystal used.

Beam 41 is polarized at 45° to the a- and c- axes of the crystal 44. Resonator 45 is designed to be resonant at the second-harmonic wavelength of essentially 497 nm. Since the second-harmonic radiation is linearly polarized along the a-axis of crystal 44, the second-harmonic radiation generated within the crystal can excite a similar a-axis polarized resonant mode of resonator 45. Thus, a beam 48 of coherent blue-green-light radiation at essentially 497 nm is produced by noncritically phased-matched SHG of beam 41 as focussed by lens 43.

The wavelength of the generated second-harmonic radiation can be controlled by tuning the fundamental diode laser wavelength so that the essentially 497 nm radiation generated is frequency locked to match the resonant wavelength of resonator 45 by directing beam 49 to detection/feedback circuitry 50 which, as in the earlier described embodiment, adjusts the injection current to diode laser 40 and/or its temperature.

It should be noted that the efficiency obtained with the configuration of Figs. 1 and 2 are essentially equivalent to the square of the finesse of their passive resonators 18, 65, respectively. The efficiency enhancement for the Fig. 3 configuration is essentially equal to the finesse of its resonator 45. The efficiency enhancement is thus less for the Fig. 3 configuration, but that configuration is simpler than that of Fig. 1 wherein only one diode laser needs to be frequency locked to a resonant mode of the resonator.

The resonator 18 or 45 may, if desired, be replaced by a ring resonator comprising three or more reflecting surfaces. These surfaces may be provided by external mirrors or by polished crystal surfaces, such as described in the June 1988 issue of the "IEEE Journal of Quantum Electronics" at pp. 913 et seq.

If desired, and as illustrated in Fig. 4, an optical waveguide 50 may be applied to an edge of a KTP crystal 51. A diode laser 52 with collimation optics and modulated output beam 53 provides essentially 994 nm fundamental radiation. Beam 53 is directed through a focussing lens 54 into the waveguide to enhance the SHG efficiency in producing a beam 55 of coherent blue-green-light radiation at essentially 497 nm. Note that with this embodiment, no locking of laser frequency to resonator frequency is needed.

It should also be noted that, according to a feature of the invention, the phase matching of the type II laser herein described is achieved by tuning the frequency of the diode laser source to that of a passive resonator by fine adjustment of the laser injection current. This is in contrast to the prior art method wherein the resonator frequency is tuned to that of the laser source by applying fields to the resonator.

While the invention has been shown and described with respect to preferred embodiments thereof especially suitable for use in optical storage applications, the invention also is highly desirable for use in printers and color displays.

## Claims

1. Apparatus for producing coherent blue-green light radiation comprising:
at least one diode laser (10, 11, 40, 52, 60) for providing a beam (12, 13, 41, 53, 61); and
a nonlinear crystal (19, 44, 51, 64) of essentially KTiOPO₄ (KTP) which produces the coherent radiation by non-critically phase-matched second harmonic conversion of said beam;
characterised in that:
the beam provided by the at least one diode laser has a wavelength of essentially 980-1,000 nm so that the blue-green light radiation has a wavelenght of essentially 490-500nm; and
the apparatus further comprises a resonator (18, 45, 65) resonant at a wavelength of essentially 980-1,000 nm and in which said crystal is disposed.

2. An apparatus as claimed in claim 1, wherein the diode laser (10, 11, 40, 52, 60) is a strained layer InGaAs/GaAs diode laser.

3. An apparatus as claimed in claim 1 or claim 2, wherein the beam (12, 13, 41, 53, 61) has a wavelength of essentially 994 nm for generating radiation having a wavelength of essentially 497 nm.

4. An apparatus as claimed in any preceding claim, wherein the resonator (18, 45, 65) consists of a pair of reflectors (20, 21, 46, 47, 66, 67) disposed adjacent opposite sides of the crystal.

5. An apparatus as claimed in any preceding claim, further comprising means (20, 21, 46, 47, 66, 67) for matching the light frequency of the essentially 980-1,000 nm beam to the resonant frequency of the resonator (18, 45, 65).

6. An apparatus as claimed in any one of claims 1 to 5, wherein the coherent radiation is propagated along the b axis of the crystal.

7. An apparatus as claimed in any one of claims 1 to 5, wherein:
the at least one diode laser is two diode lasers oriented to provide orthogonally polarised beams of essentially 980-1,000 nm wavelength; and
the non-linear crystal is oriented with its a- and c- axes parallel to the polarisation direction of said orthogonally polarised beams.

8. An apparatus as claimed in any one of claims 1 to 5, including locking means comprising:
means (26, 27) for each laser (10, 11) for generating a signal indicative of deviations in the frequency of that laser beam from a respective preselected frequency; and
means (26, 27), including feedback means, for each laser for controlling the temperature and/or injection current of that laser beam according to variations in said signal to maintain the laser beam at its respective frequency.

9. An apparatus as claimed in any one of claims 1 to 5, wherein said beam is polarised at essentially 45° to the a- and c- axes of said crystal.

10. An apparatus as claimed in claim 9, wherein:
the resonator further comprises a phaseplate (69) which is oriented such that the polarisation of the essentially 980-1,000 nm radiation is at an angle of essentially 45 degrees with respect to the a- and c- axes of the crystal when it re-enters said crystal after a round trip pass through the resonator;
and the apparatus further comprises:
means (62,71) for locking the frequency of the diode laser to a resonant frequency of the resonator.

11. An apparatus as claimed in claim 1, wherein said non-linear crystal comprises an optical waveguide oriented such that the beam is propagated along said waveguide for generating the coherent radiation by noncritically phase-matched second harmonic generation of said beam.

12. A method for producing coherent blue-green light radiation comprising the steps of:
using at least one diode laser (10, 11, 40, 52, 60) for providing a beam (12, 13, 41, 53, 61); and
producing said radiation by noncritically phase-matched second harmonic generation of said beam in a nonlinear crystal (19, 44, 51, 64) of essentially KTiOPO₄ (KTP);
characterised in that:
the blue-green light radiation has a wavelength of essentially 490-500 nm;
the beam provided by the at least one diode laser has a wavelength of essentially 980-1,000 nm; and
the crystal is disposed in a resonator (18, 45, 65) resonant at a wavelength of essentially 980-1,000 nm.

## Patentansprüche

1. Vorrichtung zum Erzeugen einer kohärenten blaugrünen Lichtstrahlung, folgendes umfassend:
mindestens einen Diodenlaser (10, 11, 40, 52, 60), der einen Strahl (12, 13, 41, 53, 61) bereitstellt; und
einen nichtlinearen Kristall (19, 44, 51, 64), im wesentlichen aus KTiOPO₄ (KTP), der die kohärente Strahlung durch unkritische phasenangepaßte Umwandlung der zweiten Harmonischen des genannten Strahls erzeugt;
dadurch gekennzeichnet, daß:
der Strahl, der von mindestens einem Diodenlaser bereitgestellt wird, eine Wellenlänge von im wesentlichen 980-1.000 nm hat, so daß die blaugrüne Lichtstrahlung eine Wellenlänge von im wesentlichen 490-500 nm hat; und
die Vorrichtung weiter einen Resonator (18, 45, 65) umfaßt, der bei einer Wellenlänge von im wesentlichen 980-1.000 nm resonanzfähig ist, und in dem der genannte Kristall angeordnet ist.

2. Eine Vorrichtung nach Anspruch 1, bei der der Diodenlaser (10, 11, 40, 52, 60) ein Diodenlaser mit einer Spannschicht aus InGaAs/GaAs ist.

3. Eine Vorrichtung nach Anspruch 1 oder Anspruch 2, bei der der Strahl (12, 13, 41, 53, 60) eine Wellenlänge von im wesentlichen 994 nm zur Erzeugung einer Strahlung mit einer Wellenlänge von im wesentlichen 497 nm hat.

4. Eine Vorrichtung nach jedem vorangehenden Anspruch, bei der der Resonator (18, 45, 65) aus einem Paar von Reflektoren (20, 21, 46, 47, 66, 67) besteht, die an gegenüberliegenden Seiten des Kristalls angeordnet sind.

5. Eine Vorrichtung nach jedem vorangehenden Anspruch, weiter umfassend Mittel (20, 21, 46, 47, 66, 67) zum Anpassen der Lichtfrequenz des Strahls von im wesentlichen 980-1.000 nm an die Resonanzfrequenz des Resonators (18, 45, 65).

6. Eine Vorrichtung nach jedem der Ansprüche 1 bis 5, bei der die kohärente Strahlung sich entlang der b-Achse des Kristalls fortpflanzt.

7. Eine Vorrichtung nach jedem der Ansprüche 1 bis 5, bei der:
der mindestens eine Diodenlaser aus zwei Diodenlasern besteht, die so ausgerichtet sind, daß sie orthogonal polarisierte Strahlen mit einer Wellenlänge von im wesentlichen 980-1.000 nm liefern; und
der nichtlineare Kristall mit seiner a- und seiner c-Achse parallel zu der Polarisationsrichtung der genannten orthogonal polarisierten Strahlen ausgerichtet ist.

8. Eine Vorrichtung nach jedem der Ansprüche 1 bis 5, Synchronisationsmittel enthaltend, die folgendes umfassen:
Mittel (26, 27) für jeden Laser (10, 11) zum Erzeugen eines Signals, das Abweichungen in der Frequenz des genannten Laserstrahls von einer jeweils vorgewählten Frequenz anzeigt; und
Mittel (26, 27), für jeden Laser Rückkoppelungsmittel enthaltend, zur Steuerung der Temperatur und/oder des Injektionsstroms dieses Laserstrahls entsprechend der Veränderungen des genannten Signals, um den Laserstrahl bei seiner jeweiligen Frequenz zu halten.

9. Eine Vorrichtung nach jedem der Ansprüche 1 bis 5, bei der der genannte Strahl bei im wesentlichen 45° zu der a- und der c-Achse des genannten Kristalls polarisiert ist.

10. Eine Vorrichtung nach Anspruch 9, bei der:
der Resonator weiter eine Phasenplatte (69) umfaßt, die so ausgerichtet ist, daß die Polarisation der Strahlung von im wesentlichen 980-1.000 nm in einem Winkel von im wesentlichen 45° zu der a- und der c-Achse des Kristalls liegt, wenn sie nach einem Umlauf durch den Resonator wieder in den genannten Kristall eintritt;
und bei der die Vorrichtung weiter umfaßt:
Mittel (62, 71) zum Synchronisieren der Frequenz des Diodenlasers mit einer Resonanzfrequenz des Resonators.

11. Eine Vorrichtung nach Anspruch 1, bei der der genannte nichtlineare Kristall einen optischen Wellenleiter umfaßt, der so ausgerichtet ist, daß der Strahl sich entlang dem genannten Wellenleiter fortpflanzt, um die kohärente Strahlung durch unkritische phasenangepaßte Erzeugung der zweiten Harmonischen des genannten Strahls zu erzeugen.

12. Ein Verfahren zum Erzeugen einer kohärenten blaugrünen Lichtstrahlung, folgende Schritte umfassend:
Einsatz von mindestens einem Diodenlaser (10, 11, 40, 52, 60) zur Bereitstellung eines Strahls (12, 13, 41, 53, 61); und
Erzeugen der genannten Strahlung durch unkritische phasenangepaßte Erzeugung der zweiten Harmonischen des genannten Strahls in einem nichtlinearen Kristall (19, 44, 51, 64), der im wesentlichen aus KTiOPO₄ (KTP) besteht;
dadurch gekennzeichnet, daß:
die blaugrüne Lichtstrahlung eine Wellenlänge von im wesentlichen 490-500 nm hat;
der von dem mindestens einem Diodenlaser bereitgestellte Strahl eine Wellenlänge von im wesentlichen 980-1.000 nm hat; und
der Kristall in einem Resonator (18, 45, 65) angeordnet ist, der bei einer Wellenlänge von im wesentlichen 980-1.000 nm resonanzfähig ist.

## Revendications

1. Appareil destiné à produire une radiation lumineuse bleu-vert cohérente comprenant :
au moins un laser à diode (10, 11, 40, 52, 60) afin de produire un faisceau (12, 13, 41, 53, 61), et
un cristal non linéaire (19, 44, 51, 64) constitué essentiellement de KTiOPO₄ (KTP) qui produit le rayonnement cohérent à l'aide d'une conversion de seconde harmonique adaptée en phase de façon non critique dudit faisceau,
caractérisé en ce que :
le faisceau produit par au moins un laser à diode présente une longueur d'onde essentiellement de 980 à 1 000 nm de façon à ce que la radiation lumineuse bleu-vert ait une longueur d'onde essentiellement entre 490 et 500 nm, et
l'appareil comprend en outre un résonateur (18, 45, 65) résonnant à une longueur d'onde essentiellement comprise entre 980 et 1 000 nm et dans lequel ledit cristal est disposé.

2. Appareil selon la revendication 1, dans lequel le laser à diode (10, 11, 40, 52, 60) est un laser à diode InGaAs/GaAs à couche sous contrainte.

3. Appareil selon les revendications 1 ou 2, dans lequel le faisceau (12, 13, 41, 53, 61) présente une longueur d'onde essentiellement de 994 nm afin de générer le rayonnement présentant d'une longueur d'onde d'essentiellement 497 nm.

4. Appareil selon toutes les revendications précédentes, dans lequel le résonateur (18, 45, 65) consiste en une paire de réflecteurs (20, 21, 46, 47, 66, 67) disposé de façon adjacente aux côtés opposés du cristal.

5. Appareil selon toutes les revendications précédentes, comprenant en outre un moyen (20, 21, 46, 47, 66, 67) pour adapter la fréquence lumineuse du faisceau constitué essentiellement entre 980 et 1 000 nm à la fréquence de résonance du résonateur (18, 45, 65).

6. Appareil selon l'une quelconque des revendications 1 à 5, dans lequel le rayonnement cohérent se propage le long de l'axe b du cristal.

7. Appareil selon l'une quelconque des revendications 1 à 5, dans lequel :
le au moins un laser à diode est constitué de deux laser à diode orientés de façon à procurer des faisceaux polarisés orthogonalement de longueur d'onde comprise essentiellement entre 980 et 1 000 nm, et
le cristal non-linéaire est orienté avec ses axes parallèles a- et c- disposés selon la direction de polarisation desdits faisceaux polarisés orthogonalement.

8. Appareil selon l'une quelconque des revendications 1 à 5, contenant des moyens de verrouillage comprenant :
des moyens (26, 27) pour chaque laser (10, 11) destinés à générer un signal indicatif des écarts de la fréquence de ce faisceau laser à partir d'une fréquence présélectionnée respective, et
des moyens (26, 27) contenant un moyen de contre réaction, pour chaque laser de façon à contrôler la température et/ou le courant injecté de ces faisceaux laser conformément aux variations dudit signal de façon à maintenir le faisceau laser à sa fréquence respective.

9. Appareil selon l'une quelconque des revendications 1 à 5, dans lequel ledit faisceau est polarisé essentiellement à 45° des axes a- et c- dudit cristal.

10. Appareil selon la revendication 9, dans lequel :
le résonateur comprend en outre une lamelle de phase (69) qui est orientée de manière à ce que la polarisation du rayonnement compris essentiellement entre 980 et 1 000 nm est à un angle d'essentiellement 45 degrés par rapport aux axes a- et c- du cristal lorsqu'il rentre à nouveau dans ledit cristal après un trajet tout autour du résonateur,
et l'appareil comprend en outre :
un moyen (62,71) destiné à verrouiller la fréquence du laser à diode sur une fréquence de résonnance du résonateur.

11. Appareil selon la revendication 1, dans lequel ledit cristal non-linéaire comprend un guide d'onde optique orienté de façon telle que le faisceau se propage le long dudit guide d'onde de façon à générer le rayonnement cohérent par une génération de seconde harmonique adaptée en phase de façon non critique dudit faisceau.

12. Procédé pour produire un rayonnement cohérent de lumière bleu-vert comprenant les étapes consistant à :
utiliser au moins un laser à diode (10, 11, 40, 52, 60) pour fournir un faisceau (12, 13, 41, 53, 61), et
produire ledit rayonnement par une génération de seconde harmonique adaptée en phase de façon non critique dudit rayon dans un cristal non linéaire (19, 44, 51, 64) constitué essentiellement de KTiOPO₄ (KTP),
caractérisé en ce que :
le rayonnement de lumière bleu-vert présente une longueur d'onde comprise essentiellement entre 480 et 500 nm,
le faisceau procuré par le au moins un laser à diode présente une longueur d'onde comprise essentiellement entre 980 et 1 000 nm, et
le cristal est disposé dans un résonateur (18, 45, 65) résonnant à une longueur d'onde comprise essentiellement entre 980 et 1 000 nm.
